# EUROPÄISCHE PATENTSCHRIFT

(11) **EP 0 473 912 B1**
(45) Veröffentlichungstag und Bekanntmachung des Hinweises auf die Patenterteilung: **13.11.1996**
(21) Anmeldenummer: 91111808.1
(22) Anmeldetag: 16.07.1991
(51) Int. Cl.: B60R 16/02

(54) **Elektrische Schaltungsanordnung und Verfahren zu deren Herstellung**
Electric circuit and method to manufacture the same
Circuit électrique et méthode de fabrication

(30) Priorität: 24.07.1990 US 557887
(43) Veröffentlichungstag der Anmeldung: 11.03.1992
(73) Patentinhaber: DEERE & COMPANY, Moline, Illinois 61265 (US)
(72) Erfinder: Holm, David Roy, Ocnomowoc, Wisconsin 53066 (US); Peterson Jr., Rudolph Andrew, Horicon, Wisconsin 53032 (US)
(74) Vertreter: Feldmann, Bernhard

(56) Entgegenhaltungen:
- DE-A- 2 409 660
- DE-A- 3 420 358
- DE-A- 3 817 879
- DE-A- 3 833 146
- DE-A- 3 836 033
- DE-U- 8 715 073

## Beschreibung

Die Erfindung betrifft eine elektrische Schaltungsanordnung für ein Fahrzeug, insbesondere für einen Rasen- und Gartenschlepper, mit einem auf einer Fahrzeugbedienungskonsole angeordneten, als Bedienungselement ausgebildeten Anlaßschalter und wenigstens einem Verriegelungsschaltkreis, welcher mehrere elektrische Komponenten sowie die zugehörigen Untersysteme, die die Betriebszustände einer oder mehrerer Fahrzeugfunktionen erfassen oder beeinflussen, aufweist (US-A-4,651,018). Die Erfindung betrifft ferner ein Verfahren zur Herstellung einer elektrischen Schaltungsanordnung.

Mit zunehmender Verwendung von Verriegelungssystemen bei Rasen- und Gartenschleppern hat auch die Komplexität der elektrischen Schaltungsanordnung, insbesondere des Zünd- oder Anlaßkreises, zugenommen. Um die Betriebszustände von Schlepperuntersystemen, wie Zapfwellenantrieb, Getriebe und Bremsen bestimmen zu können, werden zunehmend mehr Sensoren, Schalter, Relais und Leitungskreise eingesetzt. Der Einsatz der zusätzlichen Komponenten führt zu einem Absinken der Betriebssicherheit der Schaltkreise. Die härteren Einsatzbedingungen des Fahrzeuges verursachen häufig Probleme bei den Leitungsanschlüssen mit dem Ergebnis steigender Spannungsabfälle und der Unfähigkeit, Magnetspulen anzusteuern.

Bisher wurden häufig zusätzliche Relais eingesetzt, um die genannten durch Spannungsabfälle verursachten Probleme zu überwinden. Beispielsweise wurde ein Relais in einem zugänglichen Bereich hinzugefügt und über einen Kabelbaum angeschlossen. Ferner wurden Dioden zum Kabelbaum hinzugefügt. Hierdurch erhöhten sich die Herstelldauer und die Kosten. Eine einfache und saubere Montage des Systems war erschwert. Es wurde auch zunehmend schwieriger, das elektrische System während der Herstellung zu testen und bei Wartungs- und Reparaturarbeiten zu diagnostizieren und zu reparieren. Es war auch mühsam, Zusatzmerkmale, wie Zeitverzögerung, Lampenprüfung oder dergleichen in das elektrische System zu integrieren.

Die DE-A-34 20 358 beschreibt eine Lenkradausrüstung mit einem mittigen Steuerungssystem, welches eine Eingangs- und Ausgangseinrichtung umfaßt, die an einem mittigen Anbaustück des Lenkrades angebracht ist. Die Eingangs- und Ausgangseinrichtung enthält eine Schaltereinheit, die mit einem Mikrocomputer zu einer auswechselbaren Kassetteneinheit kombiniert werden kann. In der Schaltereinheit können unterschiedliche Schalter, beispielsweise Autoradioschalter, Klimaanlageschalter und Temperatursteuerschalter sowie Anzeigen eingebaut sein. Der Mikrocomputer dient der Verschlüsselung der Signale der Schaltereinheit. Die Kassetteneinheit enthält steckbare Anschlußkomponenten, durch die sie elektrisch mit einem weiteren Mikrocomputer verbindbar ist. Hierbei ist ein wahlweiser Austausch unterschiedlicher Kassetteneinheiten möglich. Dies soll eine schnelle und leichte Anpassung an die Anforderungen des Benutzers ermöglichen.

Aus der DE-A-38 36 033 ist ein elektrisches Gerät mit einer Trägerplatte aus Isolierstoff bekannt, die auf einer Seite Leiterbahnen aufweist und auf der gegenüberliegenden Seite mit elektrischen oder elektronischen Bauelementen sowie mit Steckerstiften bestückt ist, welche über Lötstellen mit den Leiterbahnen verbunden sind. Die Lötstellen sind in einem Arbeitsgang im Schwallbad einer Lötanlage herstellbar. Die ursprüngliche Trägerplatte ist in drei Bereiche unterteilt. Die äußeren Bereiche tragen die Bauelemente bzw. die Steckerstifte und sind elektrisch über Drahtbrücken, beispielsweise ein Flachbandkabel, miteinander verbunden. Nach dem Löten kann der mittlere Bereich herausgesägt werden, und die beiden äußeren Bereiche der Leiterplatte können derart verschwenkt werden, daß sich eine Anordnung ergibt, bei der die Lötstellen einander zugewandt sind und sich die Bauelemente einerseits und die Steckstifte andererseits auf gegenüberliegenden Seiten der Anordnung befinden. Zur elektrischen Isolierung der einander zugewandten Lötstellen kann zwischen diesen eine elektrische Isolierung angeordnet werden. Hierdurch soll sich ein einfaches elektrisches Gerät ergeben, daß lösbare Steckverbindungen aufweist, die auf der Leiterbahnseite von der Trägerplatte wegragen.

Die mit der Erfindung zu lösende Aufgabe wird darin gesehen, eine verbesserte elektrische Schaltungsanordnung der eingangs genannten Art sowie ein Verfahren zu deren Herstellung anzugeben, durch die die genannten Probleme überwunden werden. Insbesondere sollen bei der Schaltungsanordnung die Zuverlässigkeit bei der Herstellung und die Betriebssicherheit während des Betriebs erhöht und die Spannungsabfälle vermindert werden, um auf das Erfordernis zusätzlicher Relais, wie beispielsweise eines Anlasser-Relais, verzichten zu können. Die erfindungsgemäße Schaltungsanordnung soll sich außerhalb des Fahrzeuges während der Herstellung und bei Wartungs- und Reparaturarbeiten testen sowie rasch und einfach einbauen lassen. Die Zahl und der Umfang der Kabelbäume sollen vermindert und die Kosten des gesamten elektrischen Systems sollen gesenkt werden.

Die Aufgabe wird erfindungsgemäß dadurch gelöst, daß wenigstens eine Leiterplatte vorgesehen ist, auf der Komponenten des Verriegelungsschaltkreises angeordnet und elektrisch angeschlossen sind. Die Leiterplatte wird wenigstens teilweise von der hinter der Fahrzeugkonsole liegenden Rückseite des Anlaßschalters getragen. Auf der Leiterplatte können beispielsweise Dioden, Relais und Sicherungen angeordnet und elektrisch angeschlossen sein.

Vorzugsweise ist an die Leiterplatte wenigstens ein Kabelbaum anschließbar, der die auf der Leiterplatte angeordneten Komponenten elektrisch mit zusätzlichen Komponenten der elektrischen Schaltungsanordnung des Fahrzeuges verbindet. Als zusätzliche Komponenten kommen beispielsweise ein Zapfwellenschalter und Schalter in Betracht, durch die Signale hinsichtlich der Anwesenheit der Bedienungsperson, des Eingriffs der Parkbremse und des Bremspedals geliefert werden.

Die erfindungsgemäße Schaltungsanordnung läßt sich kompakt aufbauen. Das gesamte Verriegelungssystem des Fahrzeuges kann auf der Leiterplatte aufgebaut werden, so daß der Schaltkreis außerhalb des Fahrzeuges vor der Montage und später bei Wartungs- und Reparaturarbeiten getestet und repariert werden kann. Die Anwendung der Leiterkarte ermöglicht es, die Kabelbäume zu reduzieren und zu vereinfachen. Eine weniger teure und einfachere saubere Installation als bei den meisten bekannten Kabelbäumen ist möglich. Trotz der Verbilligung des Verdrahtungsaufwandes lassen sich zusätzliche Funktionen, wie Zeitverzögerung, Lampenprüfung und Zapfwellenüberwachung in den Schaltkreis mit lediglich geringem Aufwand integrieren. Gegenüber bekannten elektrischen Systemen werden insbesondere der Platzbedarf, die Bauteilezahl und die Montagezeit reduziert.

Einer besonders bevorzugten Ausgestaltung der Erfindung zufolge weist die Leiterplatte wenigstens einen im Bedarfsfall abtrennbaren Teilbereich auf, der von dem Anlaßschalter getragen wird. Das Abtrennen kann beispielsweise durch Abknicken oder Abbrechen entlang einer vorgegebenen Linie der Leiterplatte, die beispielsweise durch eine Nut oder Einkerbung geschwächt ist, erfolgen. Die Teilbereiche der Leiterplatte lassen sich gemeinsam fertigen und testen. Die Teilbereiche können dann bei der Montage voneinander getrennt und in räumlicher Entfernung zueinander im Fahrzeug montiert werden.

Vorzugsweise sind der abtrennbare Teilbereich und der restliche Teilbereich durch wenigstens eine flexible elektrische Verbindungsleitung, die eine räumliche Trennung der Teilbereiche ermöglicht, miteinander verbunden. Dabei können die Verbindungsleitungen als ein Flachbandkabel ausreichender Länge ausgebildet sein, deren Leitungsenden mit zueinander korrespondierenden Stellen der Teilbereiche elektrisch verbunden sind. Zweckmäßigerweise sind die korrespondierenden Stellen der Teilbereiche bei ungetrennter Leiterplatte unmittelbar durch auf die Leiterplatte aufgedruckte Leiterbahnen miteinander verbunden.

Das Abtrennen eines Teilbereiches ermöglicht eine Montage in räumlich beengten oder schlecht zugänglichen Bereichen des Fahrzeuges. Der abtrennbare Teilbereich kann beispielsweise mit einem Schalter, zum Beispiel dem Anlaßschalter verbunden sein und sich in dessen Bereich im Fahrzeug befinden, während der restliche Teilbereich an einer anderen Stelle im Fahrzeug montierbar ist. Ist bei bestimmten Anwendungen genügend Platz vorhanden und eine entfernte Anordnung der Teilbereiche nicht erforderlich, kann die gesamte Leiterplatte an einer Stelle, vorzugsweise am Anlaßschalter hinter der Bedienungskonsole befestigt werden, wobei die Leiterplatte von dem Anlaßschalter wenigstens teilweise getragen wird. Ist aus räumlichen Gründen eine Montage der ganzen Leiterplatte nicht möglich oder nicht wünschenswert, so können, wie erwähnt, die Teilbereiche entfernt voneinander angeordnet werden.

Sie sind dann durch Verbindungskabel miteinander verbunden.

Ein erfindungsgemäße Herstellungsverfahren der elektrischen Schaltungsanordnung sieht vor, daß die elektrischen Verbindungen zwischen Leiterplatte einerseits und den elektrischen Anschlüssen oder Enden des Anlaßschalters, der elektrischen Komponenten des Verriegelungsschaltkreises, der Kabelbäume und/oder der Verbindungsleitungen andererseits im wesentlichen gleichzeitig durch ein automatisches Lötverfahren hergestellt werden. Als Lötverfahren eignet sich besonders das Schwall-Löten, bei dem alle Anschlüsse gleichzeitig in einem Verfahrensschritt hergestellt werden.

Dabei wird vorzugsweise die Leiterplatte mit allen Komponenten, Bedienungselementen, Kabelbäumen und/oder Verbindungsleitungen elektrisch durch Löten verbunden. Auf der Leiterplatte können beispielsweise der Anlaßschalter, Verriegelungsrelais, Dioden, weitere Relais und Sicherungen angeordnet und unmittelbar angelötet sein. Erst nach dem Testen der gesamten Schaltungsanordnung wird diese in das Fahrzeug eingebaut. Dabei läßt sich, wie erwähnt, die Leiterplatte in wenigstens zwei Teilbereiche trennen und an räumlich voneinander getrennten Stellen des Fahrezeuges anbringen.

Trotz der Trennung der Leiterplatte in mehrere Teilbereiche ergeben sich durch die vorher angeschlossenen und die Teilbereiche verbindenden Verbindungsleitungen sehr gute elektrische Kontakte mit sehr geringen Spannungsabfällen. Hierdurch können Relais, beispielsweise das Anlasserrelais, die bei entsprechenden bisherigen Schaltungsanordnungen erforderlich waren, entfallen.

Die Verwendung einer trennbaren Leiterplatte ermöglicht es, vor dem Einbau ins Fahrzeug zu prüfen, ob für die ganze Leiterplatte an der bevorzugten Stelle genügend Platz vorhanden ist. Ist dies nicht der Fall, wird die Leiterplatte in zwei oder mehr Teilbereiche getrennt und wenigstens ein Teilbereich der Leiterplatte an einem abseitsliegenden Ort des Fahrzeuges befestigt.

Weitere vorteilhafte Ausgestaltungen und Weiterbildungen der Erfindung gehen aus den Unteransprüchen hervor.

Anhand der Zeichnung, die Ausführungsbeispiele der Erfindung zeigt, sollen die Erfindung sowie weitere Vorteile und vorteilhafte Weiterbildungen und Ausgestaltungen der Erfindung näher beschrieben und erläutert werden.

Es zeigt:
- Fig. 1: die Seitenansicht eines Fahrzeuges mit einer daran befestigten erfindungsgemäßen elektrischen Schaltungsanordnung,
- Fig. 2a: die perspektivische Darstellung einer gedruckten Leiterplatte, die gemäß der Lehre der vorliegenden Erfindung ausgeführt ist und die die Kabelbäume und Kartenverbindungsleitungen für die beiden noch nicht voneinander getrennten Abschnitte der Leiterplatte zeigt,
- Fig. 2b: eine Ansicht der Leiterplatte aus Fig. 2a mit einem abgebrochenen und entfernt angeordneten Teilbereich, der über Leitungen mit dem restlichen Teilbereich der Leiterplatte verbunden ist,
- Fig. 3: die Aufsicht der Stirnseite einer Leiterplatte, die ungeteilt an der Stelle des Anlaßschalters am Fahrzeug befestigt ist, und
- Fig. 4: eine Ansicht der Komponentenseite der Schaltungskarte aus Fig. 3.

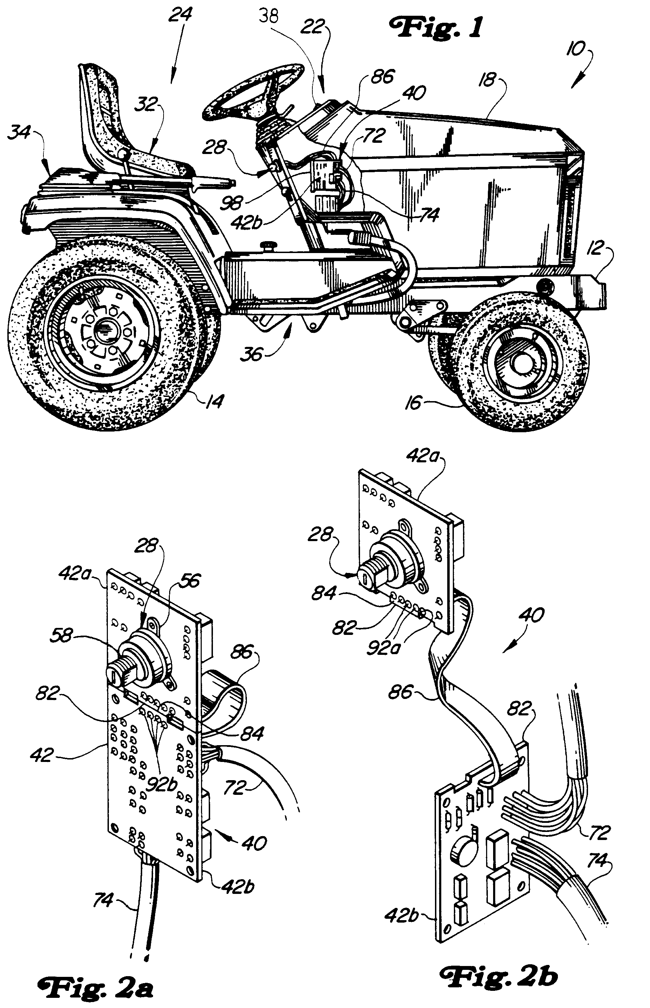

Das in Fig. 1 dargestellte Fahrzeug 10 ist ein Rasen- oder Gartenschlepper mit einem Rahmen 12, der durch die Räder 14, 16 getragen und durch eine übliche unter einer Haube 18 auf dem Rahmen befestigte Antriebsmaschine angetrieben wird. Eine Konsole oder Instrumententafel 22 am Bedienungsstand 24 enthält sowohl einen Anlaß- oder Zündschloßschalter 28 als auch übliche elektrische Anzeige- und Warnlampen, die der Fahrzeugüberwachung dienen und in der Zeichnung nicht näher dargestellt wurden. An den Stellen 32, 34 und 36 befinden sich Schalter, durch die Signale hinsichtlich der Anwesenheit der Bedienungsperson (Druckschalter), des Eingriffs der Parkbremse sowie des Bremspedals geliefert werden. Auch ein Zapfwellenantriebsschalter 38 ist auf der Konsole 22 angeordnet. Ein Aufbau, wie er hier beschrieben wurde, geht beispielsweise aus dem von der Fa. Deere & Company vertriebenen Rasenschlepper Modell 180 hervor.

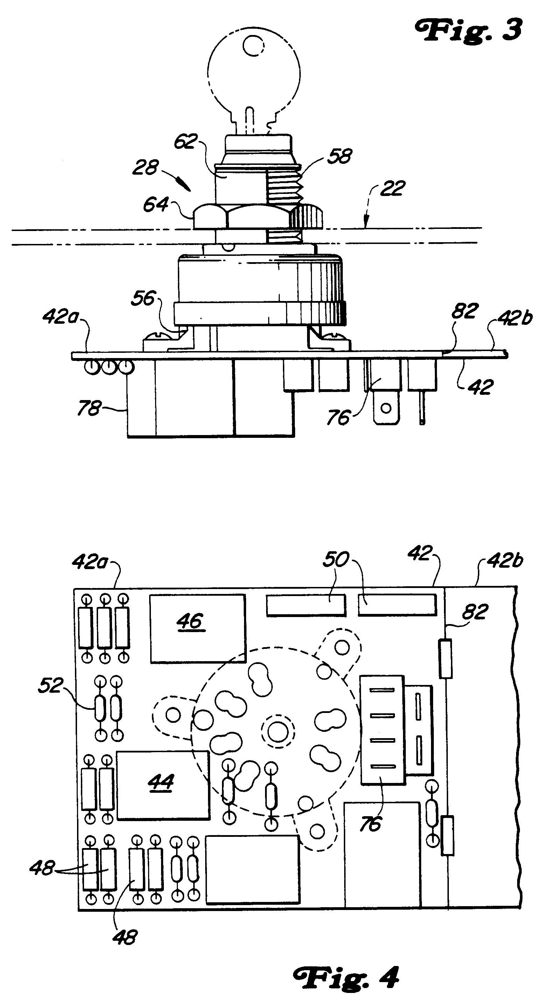

Gemäß Fig. 2a ist ein Anlasserkreismodul 40 auf einer gedruckten Schaltungskarte oder Leiterplatte 42 angeordnet, die aus zwei Teilbereichen 42a und 42b besteht. Die Leiterplatte 42 trägt elektrische Komponenten, wie Anlasserrelais 44, Zapfwellenrelais 46, Widerstände 48, Sicherungen 50 und Dioden 52 (Fig. 4).

Der Anlaßschalter 28 umfaßt eine mit dem Teilbereich 42a vernietete Befestigungsvorrichtung 56. Die elektrischen Anschlüsse des Anlaßschalters 28 erstrecken sich zur Rückseite der Leiterplatte 42, auf der sich die Komponenten 44 bis 52 befinden. Sie sind gleichzeitig mit den Komponenten 44 bis 52 auf die Schaltungskarte 42 durch ein automatisches Lötverfahren (beispielsweise durch Schwall-Lötung) aufgelötet.

Im Bereich eines der Befestigung dienenden Gewindes 58 des Anlaßschalters 28 befindet sich ein Verdrehsicherungsstreifen 62, der sich von der Leiterplatte 42 weg erstreckt und von einer passenden Ausnehmung in der Konsole 22 aufgenommen wird. Eine Sicherungsmutter 64 ist auf das Gewinde 58 aufgeschraubt und legt den Anlaßschalter 28 auf der Konsole 22 fest. Wie es am besten aus Fig. 3 hervorgeht, wird die ganze Leiterplatte 42 im wesentlichen nur von dem Anlaßschalter 28 getragen, sofern in diesem Bereich der Konsole 22 genügend Raum zur Verfügung steht. Wie weiter unten erläutert werden wird, kann alternativ hierzu auch ein abbrechbarer Teilbereich 42a von einem restlichen Teilbereich 42b der Schaltungskarte 42 getrennt werden, so daß nur der abbrechbare Teilbereich 42a von dem Anlaßschalter 28 auf der Konsole 22 getragen wird. Diese Lösung eignet sich dann, wenn der Raum im Bereich der Konsole 22 begrenzt ist und einen guten Zugang nicht erlaubt.

Die Leiterplatte 42 sowie verschiedene Elemente, wie die am Fahrzeug befindlichen Verriegelungsschalter, Anlaßkomponenten und Starter, sind durch Kabelbäume 72 und 74 miteinander verbunden. Wie aus der Ausgestaltung gemäß Fig. 3 und 4 hervorgeht, sind Anschlußstecker 76 und 78 auf die Leiterplatte 42 gelötet. Die Anschlußstecker 76 und 78 dienen der Aufnahme entsprechender Steckelemente an den Enden der Kabelbäume 72 und 74. Um jedoch Spannungsabfälle an den Kabelbaumanschlüssen zu vermindern, sind die Kabelbaumenden vorzugsweise direkt mit den entsprechenden Lötpunkten der Leiterplatte 42 verlötet (Fig. 2a und 2b). Bei dem automatischen Schwall-Lötverfahren werden gleichzeitig mit den Kabelbäumen 72, 74 andere Komponenten auf die Leiterplatte 42 gelötet. Die Enden der Kabelbäume 72, 74 können auch unmittelbar mit den Sensoren (beispielsweise die erwähnten Schalter, durch die Signale hinsichtlich der Anwesenheit einer Bedienungsperson, des Eingriffs der Parkbremse und des Bremspedals gewonnen werden) verlötet werden, wodurch die Spannungsabfälle weiter reduziert und die Anzahl der für eine gegebene Schaltkreiskonfiguration erforderlichen Relais gesenkt werden können.

Die sich bei direkter Verdrahtung ergebenden verminderten Spannungsabfälle ermöglichen es, auf ein gewöhnlich im Anlaßkreis enthaltenes Starterrelais zu verzichten. An Stelle dessen kann der Anlaßschalter 28 unmittelbar über den Verriegelungskreis der Leiterplatte 42 mit dem Starter des Fahrzeuges 10 verbunden werden.

Wie aus den Figuren 2 bis 4 hervorgeht, ist die Leiterplatte 42 eingekerbt oder auf andere Weise entlang der Linie 82 geschwächt, so daß die Teilbereiche 42a und 42b voneinander abgebrochen werden können, wenn es erforderlich ist, den Anlaßschalter 28 auf einem Teilbereich 42a anzuordnen, der beabstandet zu dem Teilbereich 42b liegt (wie es in Fig. 1 gezeigt ist, wo für eine bequeme Zugänglichkeit die Teilbereiche 42a und 42b räumlich getrennt sind). Die Leiterplatte 42 enthält eng beieinanderliegende Leiterbahnen 84, die sich bei ungeteilter Leiterplatte 42 über die Linie 82 hinaus erstrecken und die beiden Teilbereiche 42a und 42b miteinander verbinden. Mit dem Auseinanderbrechen der Leiterplatte 42 in zwei Teilbereiche 42a und 42b werden die Leiterbahnen 84 unterbrochen. Um die erforderliche elektrische Verbindung zwischen den Teilbereichen 42a und 42b herzustellen, werden die Enden eines mehradrigen Flachbandkabels 86 durch Schwall-Löten mit Lötstellen 92a und 92b verbunden, die auf den sich hinsichtlich der Linie 82 gegenüberliegenden Leiterbahnen 84 liegen. Das Flachbandkabel 86 wird auf die noch zusammenhängende, nicht auseinandergebrochene Leiterplatte 42 (Fig. 2) gleichzeitig mit den Komponenten 44 bis 52, dem Anlaßschalter 28 und den Enden der Kabelbäume 72, 74 aufgelötet. Die ganze Leiterplatte 42 kann zunächst als eine einzige Einheit hergestellt und später mit dem bereits aufgelöteten Flachbandkabel 86 in zwei Teilbereiche 42a und 42b auseinandergebrochen werden. Die unmittelbare Verdrahtung ermöglicht es, gemeinsam mit den verlöteten Verbindungen mittels Flachbandkabel 86, daß ein Starterrelais, das üblicherweise im Anlasserkreis enthalten ist, entfallen kann.

Wie Fig. 1 zeigt, wird der den Anlaßschalter 28 aufnehmende Teilbereich 42a durch die Konsole 22 über den Anlaßschalter 28 getragen. Der übrige Teilbereich 42b ist am Fahrzeugrahmen 12 durch eine Halterung 98 befestigt und erlaubt einen bequemen Zugang während der Montage sowie der Wartungs- und Reparaturarbeiten des Fahrzeuges 10. Vor dem Einbau in das Fahrzeug 10 und auch während der Wartungsarbeiten am Fahzeug 10 läßt sich der Fahrzeugschaltkreis außerhalb des Fahrzeuges 10 überprüfen. Ferner können zusätzliche Bauelemente, wie beispielsweise Zeitrelaiskreise, Lampenüberprüfkreise oder Zapfwellenbremsspulenkreise leicht in dem Teilbereich 42b integriert werden.

## Patentansprüche

1. Elektrische Schaltungsanordnung für ein Fahrzeug, insbesondere einen Rasen- und Gartenschlepper, mit einem im Bedienungsstand (24) des Fahrzeuges (10) auf der Fahrzeugkonsole (22) befestigten Anlaßschalter (28) und wenigstens einem Verriegelungsschaltkreis, welcher mehrere elektrische Komponenten (44 - 52) sowie die zugehörigen, die Betriebszustände einer oder mehrerer Fahrzeugfunktionen erfassenden oder beeinflussenden Untersysteme aufweist, dadurch gekennzeichnet, daß wenigstens eine Leiterplatte (42) vorgesehen ist, auf der Komponenten (44 - 52) des Verriegelungsschalt kreises angeordnet und elektrisch angeschlossen sind, und die wenigstens teilweise von der hinter der Fahrzeugkonsole (22) liegenden Rückseite des Anlaßschalters (28) getragen wird.

2. Schaltungsanordnung nach Anspruch 1, dadurch gekennzeichnet, daß der Anlaßschalter (28) elektrisch an Leiterbahnen der Leiterplatte (42) angeschlossen ist.

3. Schaltungsanordnung nach Anspruch 1 oder 2, dadurch gekennzeichnet, daß an die Leiterplatte (42) wenigstens ein Kabelbaum (72, 74) angeschlossen ist, der die auf der Leiterplatte (42) angeordneten Komponenten (44 - 52) elektrisch mit zusätzlichen Komponenten (32, 34, 36) der elektrischen Schaltungsanordnung des Fahrzeuges (10) verbindet.

4. Schaltungsanordnung nach einem der Ansprüche 1 bis 3, dadurch gekennzeichnet, daß die Leiterplatte (42) wenigstens einen bedarfsweise abtrennbaren, vorzugsweise abbrechbaren Teilbereich (42a) aufweist, der von dem Anlaßschalter (28) getragen wird.

5. Schaltungsanordnung nach Anspruch 4, dadurch gekennzeichnet, daß der abtrennbare Teilbereich (42a) und der restliche Teilbereich (42b) durch wenigstens eine flexible Verbindungsleitung (86), die eine räumliche Trennung der Teilbereiche (42a, 42b) ermöglicht, elektrisch miteinander verbunden sind.

6. Schaltungsanordnung nach Anspruch 5, dadurch gekennzeichnet, daß die Verbindungsleitungen als Flachbandkabel (86) ausreichender Länge ausgebildet sind, deren Leitungsenden mit zueinander korrespondierenden Stellen der Teilbereiche (42a, 42b) elektrisch verbunden sind.

7. Schaltungsanordnung nach Anspruch 6, dadurch gekennzeichnet, daß die korrespondierenden stellen der Teilbereiche (42a, 42b) bei ungetrennter Leiterplatte (42) unmittelbar durch Leiterbahnen (84) auf der Leiterplatte (42) miteinander verbunden sind.

8. Verfahren zur Herstellung einer elektrischen Schaltungsanordnung nach einem der Ansprüche 1 bis 7, dadurch gekennzeichnet, daß die elektrischen Verbindungen zwischen Leiterplatte (42) einerseits und den elektrischen Anschlüssen oder Enden des Anlaßschalters (28), der elektrischen Komponenten (44 - 52) des Verriegelungsschaltkreises, der Kabelbäume (72, 74) und/oder der Verbindungsleitungen (86) andererseits im wesentlichen gleichzeitig durch ein automatisches Lötverfahren hergestellt werden.

9. Verfahren nach Anspruch 8, dadurch gekennzeichnet, daß als Lötverfahren das Schwall-Löten dient.

10. Verfahren nach Anspruch 8 oder 9, dadurch gekennzeichnet, daß die Leiterplatte (42) mit allen Komponenten bestückt, mit den Bedienungselementen (28), den Kabelbäumen (72, 74) und/oder den Verbindungsleitungen (86) elektrisch verbunden und getestet wird, bevor sie in das Fahrzeug eingebaut wird.

11. Verfahren nach einem der Ansprüche 8 bis 10, dadurch gekennzeichnet, daß wenigstens zwei Teilbereiche (42a, 42b) einer trennbaren Leiterplatte (42) an räumlich voneinander getrennten Stellen des Fahrzeuges (10) angebracht werden.

12. Verfahren zur Herstellung eines Zünd- oder Anlasserkreises für einen Rasen- und Gartenschlepper mit Bedienungsstand (24), wobei der Zünd- und Anlasserkreis mehrere elektrische Komponenten (44 - 52) sowie die zugehörigen, die Betriebszustände einer oder mehrerer Fahrzeugfunktionen erfassenden oder beeinflussenden Untersysteme aufweist, gegebenenfalls nach einem der Ansprüche 8 bis 11, dadurch gekennzeichnet,
- daß eine einzige, nachträglich in wenigstens zwei Bereiche trennbare Leiterplatte (42) hergestellt wird, auf der Komponenten (44 - 52) des Verriegelungsschaltkreises angeordnet und elektrisch angeschlossen sind,
- daß ein abtrennbarer Bereich der Leiterplatte (42) an einem Bedienungselement (28), vorzugsweise einem Anlaßschalter, befestigt wird,
- daß ermittelt wird, ob am Bedienungsstand (24) genügend Platz zugänglich ist, um das Bedienungselement (28) mit der ganzen Leiterplatte (42) als ein einziges Bauteil anzubauen, und
- daß das Bedienungselement (28) mit dem daran befestigten abtrennbaren Bereich der Leiterplatte (42) an dem Bedienungsstand (24) befestigt wird, wobei entweder das Bedienungselement (28) mit der ganzen Leiterplatte (42) als ein einziges Bauteil an dem Bedienungsstand (24) befestigt wird, falls dort genügend Platz vorhanden ist, oder ein Teil der Leiterplatte (42) abgetrennt und an einer entfernt liegenden Stelle angeordnet wird, falls im Bereich des Bedienungselements (28) nicht genügend Platz vorhanden ist.

## Claims

1. An electrical circuit assembly for a vehicle, in particular a lawn and garden tractor, with an ignition switch (28) secured on the console (22) in the operator's station (24) of the vehicle (10) and at least one interlock circuit, which has several electrical components (44-52) as well as the associated subsystems detecting or influencing the operating states of one or more vehicle functions, characterised in that at least one circuit board (42) is provided, on which components (44-52) of the interlock circuit are arranged and electrically connected, and which is at least partially supported by the rear side of the ignition switch (28) located behind the vehicle console (22).

2. Circuit assembly according to Claim 1, characterised in that the ignition switch (28) is electrically connected to conduction paths of the circuit board (42).

3. Circuit assembly according to Claim 1 or 2, characterised in that at least one wiring harness (72, 74) is connected to the circuit board (42) which electrically connects the components (44-52) arranged on the circuit board (42) to additional components (32, 34, 36) of the electrical circuit assembly of the vehicle (10).

4. Circuit assembly according to one of Claims 1 to 3, characterised in that the circuit board (42) has at least one section (42a), which may be separated as required and may preferably be broken away, and which is supported by the ignition switch (28).

5. Circuit assembly according to Claim 4, characterised in that the separable section (42a) and the remaining section (42b) are electrically connected to one another by at least one flexible connection line (86) which enables spatial separation of the sections (42a, 42b).

6. Circuit assembly according to Claim 5, characterised in that the connection lines are constructed in the form of ribbon wire (86) of sufficient length, the line ends of which being electrically connected to corresponding points of the sections (42a, 42b).

7. Circuit assembly according to Claim 6, characterised in that when the circuit board (42) is not separated, the corresponding points of the sections (42a, 42b) are directly interconnected by conduction paths (84) on the circuit board (42).

8. Method of manufacturing an electrical circuit assembly according to one of Claims 1 to 7, characterised in that the electrical connection between circuit board (42), on the one hand, and the electrical terminals or ends of the ignition switch (28), the electrical components (44-52) of the interlock circuit, the wiring harnesses (72, 74) and/or the connection lines (86), on the other hand, are manufactured substantially simultaneously using an automated soldering process.

9. Method according to Claim 8, characterised in that wave soldering is the soldering process used.

10. Method according to Claim 8 or 9, characterised in that the circuit board (42) is fitted with all components, is electrically connected to the operating elements (28), the wiring harnesses (72, 74) and/or the connection lines (86), and tested before it is installed into the vehicle.

11. Method according to one of Claims 8 to 10, characterised in that at least two sections (42a, 42b) of a separable circuit board (42) are attached to spatially separate points on the vehicle (10).

12. Method of manufacturing an ignition or starter circuit for a lawn and garden tractor with operator's station (24), wherein the ignition and starter circuit has several electrical components (44-52) as well as the associated subsystems detecting or influencing the operating states of one or more vehicle functions, possibly according to one of Claims 8 to 11, characterised in that
- a single circuit board (42) is manufactured which may be separated subsequently in at least two regions and on which components (44-52) of the interlock circuit are arranged and electrically connected;
- that a separable region of the circuit board (42) is secured to an operating element (28), preferably to an ignition switch;
- that it is determined whether sufficient space is accessible on the operator's station (24) to mount the operating element (28) with the entire circuit board (42) as a single assembly, and
- that the operating element (28), with the separable region of the circuit board (42) secured to it, is attached to the operator's station (24), in which case the operating element (28) is either attached with the entire circuit board (42) as a single assembly to the operator's station (24), should there be sufficient space there, or a part of the circuit board (42) is separated and arranged at a remote location, should there not be sufficient space in the region of the operating element (28).

## Revendications

1. Circuit électrique pour un véhicule, notamment un tracteur de jardin-tondeuse à gazon, comportant un contacteur de démarrage (28) fixé sur le tableau de commande (24) du véhicule (10), sur la console (22) de ce dernier, et au moins un circuit de verrouillage, qui comporte plusieurs composants électriques (44-52) ainsi que les systèmes secondaires associés, qui détectent ou influent sur les états de fonctionnement d'une ou de plusieurs fonctions du véhicule, caractérisé en ce qu'il est prévu au moins une plaquette à circuits imprimés (42), sur laquelle sont disposés des composants (44-52) du circuit de verrouillage, qui sont raccordés électriquement, et qui est portée au moins partiellement par la face arrière du contacteur de démarrage (28), qui est situé en arrière de la console (22) du véhicule.

2. Circuit selon la revendication 1, caractérisé en ce que le contacteur de démarrage (28) est raccordé électriquement aux voies conductrices de la plaquette à circuits imprimés (42).

3. Circuit selon la revendication 1 ou 2, caractérisé en ce qu'à la plaquette à circuits imprimés (42) est raccordé au moins un faisceau de câbles (72,74), qui relie électriquement les composants (44-52), disposés sur la plaquette à circuits imprimés (42), à des composants supplémentaires (32,34,36) du circuit électrique de véhicule du circuit électrique du véhicule (10).

4. Circuit selon l'une des revendications 1 à 3, caractérisé en ce que la plaquette à circuits imprimés (42) comporte au moins une partie (42a), qui est séparable le cas échéant et peut de préférence être sectionnée et qui est portée par le contacteur de démarrage (28).

5. Circuit selon la revendication 4, caractérisé en ce que la partie séparable (42a) et la partie restante (42b) sont reliées électriquement entre elles par au moins une ligne de raccordement flexible (86), qui permet une séparation spatiale des parties (42a,42b).

6. Circuit selon la revendication 5, caractérisé en ce que les lignes de raccordement sont agencées sous la forme de câbles plats (86) possédant une longueur suffisante, dont les extrémités sont reliées électriquement à des emplacements, qui se correspondent, des parties (42a, 42b).

7. Circuit selon la revendication 6, caractérisé en ce que les emplacements correspondants des parties (42a, 42b) sont reliés entre eux directement par des voies conductrices (84) situées sur la plaquette à circuits imprimés (42), dans le cas où la plaquette à circuits imprimés (42) n'est pas détachée.

8. Procédé pour fabriquer un circuit électrique selon l'une des revendications 1 à 7, caractérisé en ce que les liaisons électriques entre la plaquette à circuits imprimés (42) d'une part et les bornes ou extrémités électriques du contacteur de démarrage (28), des composants électriques (44-52) du circuit de verrouillage, des faisceaux de câbles (72,74) et/ou des conducteurs de liaison (86) d'autre part sont établies simultanément au moyen d'un procédé de brasage automatique.

9. Procédé selon la revendication 8, caractérisé en ce qu'on utilise comme procédé de brasage le brasage a la vague.

10. Procédé selon la revendication 8 ou 9, caractérisé en ce qu'on relie électriquement la plaquette à circuits imprimés (42) est équipée de tous les composants, aux éléments de commande (28), aux faisceaux de câbles (72, 74) et/ou aux conducteurs de raccordement (86) et qu'on la teste avant son montage dans le véhicule.

11. Procédé selon l'une des revendications 8 à 10, caractérisé en ce qu'on installe au moins deux parties (42a,42b) d'une plaquette à circuits imprimés séparable (42) en des emplacements, séparés spatialement, du véhicule (10).

12. Procédé pour fabriquer un circuit d'allumage ou de démarrage pour un tracteur de jardin-tondeuse à gazon comportant un tableau de commande (24), selon lequel le circuit d'allumage et de démarrage comporte plusieurs composants électriques (44-52) ainsi que les systèmes secondaires associés, qui détectent ou influent sur les états de fonctionnement d'une ou de plusieurs fonctions du véhicule, éventuellement selon l'une des revendications 8 à 11, caractérisé en ce
- qu'on fabrique une plaquette à circuits imprimés (42) pouvant être séparée ultérieurement en au moins deux parties, sur laquelle des composants (44-52) du circuit de verrouillage sont disposés et raccordés électriquement,
- qu'on fixe une partie séparable de la plaquette à circuits imprimés (42) sur un élément de commande (28), de préférence un contacteur de démarrage,
- qu'on détermine si une place suffisante est accessible sur le panneau de commande (24) pour monter l'élément de commande (28) pourvu de l'ensemble de la plaquette à circuits imprimés (42), sous la forme d'un composant monobloc, et
- qu'on fixe l'élément de commande (28), au moyen de la partie séparable de la plaquette à circuits imprimés (42), qui est fixée à cet élément, sur le panneau de commande (24), et soit on fixe l'élément de commande (28) pourvu de l'ensemble de la plaquette à circuits imprimés (42) sous la forme d'un composant monobloc sur le panneau de commande (24), dans le cas où une place suffisante est présente en cet endroit, soit on sépare une partie de la plaquette à circuits imprimés (42) et on l'installe en un emplacement éloigné, dans le cas où il n'existe pas une place suffisante au voisinage de l'élément de commande (28).
